(19) Europäisches Patentamt
European Patent Office
Office européen des brevets

(11) **EP 2 615 133 A1**

(12) **DEMANDE DE BREVET EUROPEEN**

(43) Date de publication:
**17.07.2013 Bulletin 2013/29**

(51) Int Cl.:
*C08K 3/38* (2006.01)    *C08K 9/04* (2006.01)
*H01L 23/373* (2006.01)    *H01B 3/00* (2006.01)

(21) Numéro de dépôt: **12305045.2**

(22) Date de dépôt: **12.01.2012**

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**
Etats d'extension désignés:
**BA ME**

(71) Demandeur: **Bruker Biospin (Société par Actions
Simplifiée)
67160 Wissembourg (FR)**

(72) Inventeurs:
• **Abenhaim, Jacques
67160 Wissenburg (FR)**
• **Jaspard, Frédéric
67160 Wissenburg (FR)**

(74) Mandataire: **Nuss, Pierre et al
Cabinet Nuss
10 Rue Jacques Kablé
67080 Strasbourg Cedex (FR)**

(54) **Matériau composite à conductivité améliorée, pièce formée à partir d'un tel matériau et applications**

(57)    La présente invention a pour objet un matériau composite électriquement isolant avec une résistivité électrique supérieure à $10^{10}$ Ω.m, caractérisé en ce qu'il est constitué, en poids par rapport au poids total dudit matériau composite, par :
- au moins 45 % d'une matrice de (co)polymère(s) semi-cristallin(s) et thermoplastique(s),
- entre 20 % et 54,5 % d'une charge de hBN et
- entre 0,5 % et 5 %, de préférence entre 1 % et 3 %, d'un agent de couplage destiné à améliorer l'affinité entre ledit au moins un (co)polymère et ladite charge.

Elle a encore pour objet une pièce formée, notamment par extrusion ou injection d'un matériau composite selon l'invention, caractérisée en ce qu'elle présente une conductivité thermique normale au plan d'injection ou d'extrusion d'au moins 0,8 W/m.K, de préférence d'au moins 1,0 W/m.K et plus préférentiellement d'au moins 1,2 W/m.K.

Enfin, la présente invention a également pour objet l'utilisation d'une pièce formée selon l'invention comme élément d'échange thermique dans un dispositif dans lequel a lieu un échange de calories.

EP 2 615 133 A1

**Description**

La présente invention concerne le domaine des matériaux, en particulier celui des matériaux composites et plus particulièrement celui des matériaux composites thermoplastiques semi-cristallins utilisés dans le domaine des échangeurs de calories / frigories dans lequel un transfert d'un milieu chaud vers un milieu froid et vice-versa a lieu et ledit transfert devant généralement être optimisé.

De nombreux matériaux composites connus comprennent une matrice en polymère et un renfort pour améliorer des propriétés mécaniques, électriques ou thermiques. Les progrès considérables en miniaturisation des composants et cartes électroniques rendent crucial une bonne gestion de la dissipation thermique. C'est pourquoi les matériaux plastiques conducteurs thermiques et isolants électriques ont un grand intérêt. Outre les mécanismes physiques de transmission de la chaleur, la taille, la forme et la proportion de la charge jouent un rôle prépondérant dans conductivité thermique (ci-après également désignée par TC). Dans la suite, sauf indication contraire, les proportions ou teneurs indiquées sont rapportées au poids, c'est-à-dire à la masse totale du matériau considéré.

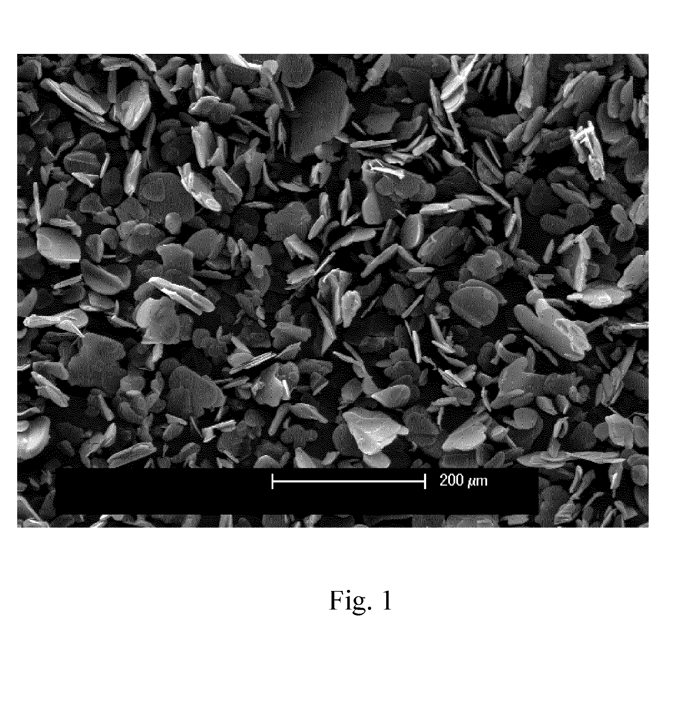

Beaucoup de charges présentent une anisotropie dans les propriétés mécaniques ou physiques, dont la conductivité thermique (TC). Cette anisotropie venant de la forme en flocon ou en fibre et/ou de la matière elle même. Le nitrure de bore sous sa forme cristallographique hexagonale hBN a, par exemple, une TC de 600 W/m.K selon la direction ab et seulement de 30 W/m.K selon la direction c (cf. fig. 1 : photo MEB de hBN en flocon gracieusement mise à disposition par la société Henze Boron Nitride Products GmbH).

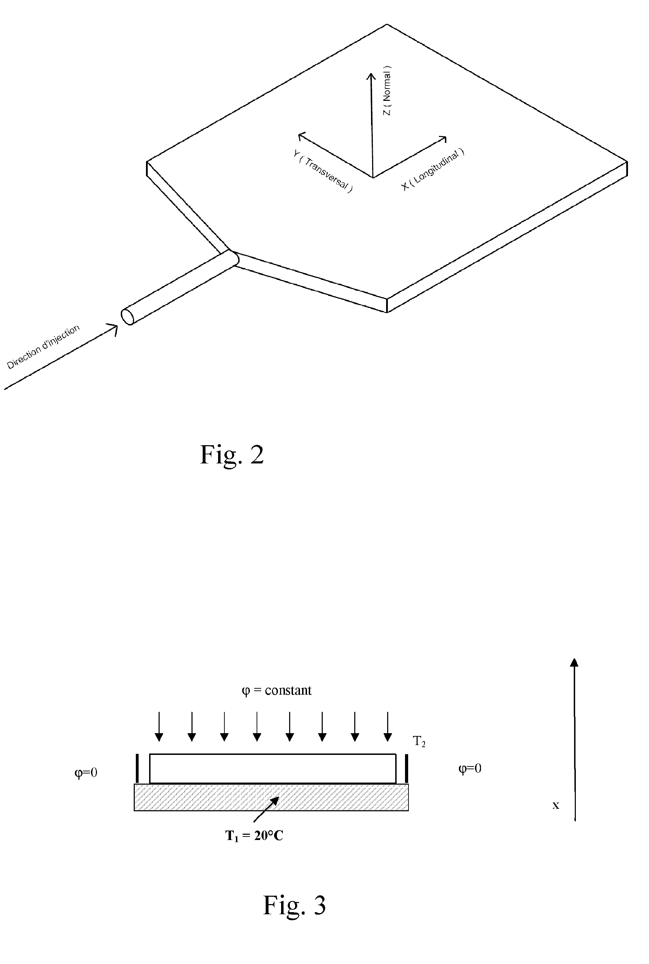

Un procédé classique d'injection remplit un moule par de la matière thermoplastique en appliquant une forte pression qui peut atteindre 200 MPa. Les charges de type fibre ou en flocon sont orientées dans le sens de l'écoulement dit « longitudinal ». Ce qui a pour conséquence une forte anisotropie dans la TC. On distingue 3 directions principales : transversale, normale et longitudinale, et donc trois TC différentes : $TC_{transversal}$, $TC_{Normal}$, $TC_{longitudinal}$. (voir fig. 2). Un procédé classique d'extrusion oriente également la matière selon une direction préférentielle, bien que les pressions soient plus faibles que pour un procédé d'injection.

La conductivité thermique λ (ou TC), donne la capacité d'un matériau à dissiper la chaleur. La loi de Fourier dans un solide s'écrit :

$$\vec{\varphi} = -\lambda \cdot \overrightarrow{gradT}$$

le flux de chaleur φ étant proportionnel à la conductivité thermique λ et au gradient de température. L'unité de la TC est le $\dfrac{W}{mK}$.

L'autre grandeur pertinente dans le présent contexte est la capacité thermique massique Cp : la quantité d'énergie à apporter à l'unité de masse d'un milieu pour augmenter sa température de 1 K.

$$Cp = \frac{1}{m} \cdot \frac{dQ}{dT}.$$

L'unité de Cp est le $\dfrac{J}{kg.K}$. On trouve également la diffusivité à donner par : $a = \dfrac{\lambda}{\rho Cp}$, son unité étant le $\dfrac{m^2}{s}$.

Dans le cas d'un échange de chaleur aux interfaces, on définit le coefficient d'échange h. Il relie la puissance dissipée P par une surface S avec le milieu environnant :

$P = h \cdot S \cdot (T_p - T_\infty)$, l'unité de h étant $\dfrac{W}{m^2.K}$. $T_p$ est la température de paroi et $T_\infty$ la température du milieu environnant.

Par analogie avec le domaine de l'électricité, on définit la résistance thermique $R_{th}$ par $\Delta T = R_{th} \cdot P$, où P est la puissance échangée et $\Delta T$ la différence de température entre deux surfaces d'un solide (conduction) ou entre une surface externe et un fluide (convection).

L'unité de $R_{th}$ est le $\dfrac{K}{W}$. On peut considérer $R_{th}$ comme l'analogue de la résistance électrique R. Il en va de même pour les autres grandeurs :

| Thermique | Electrique |
|---|---|
| $\Delta T$ [K] | Tension U [V] |
| P [W] | Courant I [A] |
| $R_{th} \quad \left[\dfrac{K}{W}\right]$ | R[$\Omega$] |
| $\Delta T = R_{th} \cdot P$ | U = R.I |

Cette analogie est très utile pour décrire des problèmes de thermique sous forme de circuit électrique, ce qui simplifie leur résolution. On trouve également l'analogue du condensateur électrique avec la capacité thermique massique, ce qui est utile en régime transitoire. En régime permanent on considère seulement un réseau de résistances.

De nombreux principes de mesure de TC existent, que l'on peut classer dans deux catégories : les méthodes en régime permanent (dont celle dite de « plaque chaude gardée », selon la norme ISO 8302) et les méthodes en régime transitoire où l'analyse dynamique d'une montée en température provoquée par un élément chauffant permet de calculer la diffusivité thermique, la capacité thermique massique et la conductivité thermique.

La mesure de TC faite dans le cadre de la présente invention est réalisée par un appareil de conception propre, qui fonctionne en régime permanent. L'échantillon est dans ce cas un disque d'un diamètre de 26 mm et d'une épaisseur de 2 mm qui est usiné dans une plaque comme celle représentée à la figure 2. Cet échantillon est chauffé par tout moyen approprié, sur une face et refroidi sur sa face inférieure. De par sa conception le flux de chaleur est unidirectionnel, et les flancs sont adiabatiques, ce qui exclut un couplage entre la direction normale et les directions longitudinales ou transverses. Deux thermocouples mesurent la température de la plaque froide régulée T1 et la température de la face chauffée T2.

Si on note P la puissance de chauffe, S la section du disque et ep son épaisseur. On a $\varphi = \dfrac{P}{S}$ (chauffe unidirectionnelle). En régime permanent, la répartition de la température est linéaire, donc $T(x) = \dfrac{T_2 - T_1}{ep} \cdot x + T_1$,

on en déduit $grad(T) = \dfrac{T_2 - T_1}{ep}$.

La loi de Fourier donne $\varphi_x = -\dfrac{P}{S} = -\lambda \cdot \dfrac{(T_2 - T_1)}{ep}$, donc $\lambda = \dfrac{ep}{S \cdot (T_2 - T_1)} \cdot P$.

Connaissant la puissance de chauffe P et les deux températures aux extrémités de l'échantillon, on en déduit, grâce à cette méthode, la conductivité thermique normale à la direction d'injection sans ambigüité. En effet, certaines méthodes sont moins adaptées à la mesure des matériaux composites anisotropes comme par exemple une mesure selon la norme ASTM E 1461-01.

La présente invention a pour but de pallier les inconvénients des matériaux existants et notamment de proposer de nouveaux matériaux permettant de réaliser des pièces bi ou tridimensionnelles, en particulier des pièces injectées ou extrudées qui présentent des valeurs de conductivité thermique dans la direction normale (Z), c'est-à-dire normale au plan d'injection ou d'extrusion d'au moins 0,8 W/m.K, de préférence d'au moins 1,0 W/m.K et plus préférentiellement d'au moins 1,2 W/m.K ainsi que les applications ou utilisations de ces pièces dans l'industrie.

Elle a donc pour objet un matériau composite électriquement isolant avec une résistivité électrique supérieure à $10^{10}$ $\Omega$.m, caractérisé en ce qu'il est constitué, en poids par rapport au poids total dudit matériau composite, par :

- au moins 45 % d'une matrice de (co)polymère(s) semi-cristallin(s) et thermoplastique(s),

- entre 20 % et 54,5 % d'une charge de hBN (nitrure de bore hexagonal), destinée à augmenter la conductivité thermique normale d'une pièce formée obtenue par injection ou extrusion dudit matériau composite, ledit hBN utilisé ayant une taille de particules moyenne D50 comprise entre 10 $\mu$m et 45 $\mu$m, de sorte que ladite pièce formée en matériau composite présente une conductivité thermique normale au plan d'injection ou d'extrusion d'au moins 0,8 W/m.K,
- entre 0,5 % et 5 %, de préférence entre 1 % et 3 %, d'un agent de couplage destiné à améliorer l'affinité entre ledit au moins un (co)polymère et ladite charge,

la somme des teneurs précitées pondérales étant égale à 100 %.

Elle a encore pour objet une pièce formée, notamment par extrusion ou injection d'un matériau composite selon l'invention, caractérisée en ce qu'elle présente une conductivité thermique normale au plan d'injection ou d'extrusion d'au moins 0,8 W/m.K, de préférence d'au moins 1,0 W/m.K et plus préférentiellement d'au moins 1,2 W/m.K.

Enfin, la présente invention a encore pour objet l'utilisation d'une pièce formée selon l'invention, notamment sous la forme d'un tube, d'une gaine, d'une ailette ou similaire comme élément d'échange thermique dans un dispositif dans lequel a lieu un échange de calories, échange que l'on souhaite habituellement optimiser, notamment de type radiateur, échangeur de chaleur, circuit de refroidissement, gaine électriquement isolante de câbles électriques, et analogues.

L'invention sera mieux comprise, grâce à la description ci-après, qui se rapporte à des modes de réalisation préférés, donnés à titre d'exemples non limitatifs, et expliqués avec référence aux dessins schématiques annexés, dans lesquels :

- 1a figure 1 représente une photo MEB d'un échantillon de nitrure de bore en flocons ;
- la figure 2 représente, de façon schématique, un exemple de pièce injectée et les directions de conductions au sens de la présente invention ;
- la figure 3 représente, de façon schématique, le dispositif de mesure de la conduction thermique utilisé dans le cadre de la présente invention ;
- la figure 4 représente un graphique indiquant la conductivité thermique normale d'un matériau composite selon l'invention en fonction du taux de charge ;
- la figure 5 représente, de façon schématique simplifiée, la section d'un câble haute tension selon l'exemple de l'invention ; et
- la figure 6 représente un graphique indiquant le courant maximum dans le câble de l'exemple de l'invention en fonction du coefficient d'échange.

On a procédé à des mesures de TC sur des échantillons du commerce. Les résultats sont consignés dans le tableau ci-après.

| Composite thermoplastique | Conducteur électrique | TC fiche Technique [W/mK] | TC$_{normale}$ mesurée selon l'invention [W/mK] |
|---|---|---|---|
| PA66 chargé 60 % verre et graphite | Oui | 4,5 | 2,2 |
| PPS chargé 60 % verre et graphite | Oui | 3,7 | 1,95 |
| PA66 chargé 60 % verre et minéral | Non | 1,4 | 1,02 |
| PPS chargé 60 % verre et minéral | Non | 1,2 | 0,94 |
| PPS chargé verre et minéral | Non | 8,0 | 1,0 |
| PA66 chargé 60 % verre et graphite | Oui | 5,50 (TC$_{normale}$) | 2,26 |

On constate d'énormes différences entre les mesures, probablement dues aux méthodes de mesure et au fait que la direction de mesure n'est pas toujours renseignée. On notera que la préparation de l'échantillon peut aussi influer sur la TC : injection moulage, compression moulage, extrusion, conditions de dégazage... La méthode de mesure selon l'invention est la plus pessimiste et certainement réaliste, car elle interdit un couplage thermique dans le plan de l'échantillon.

Par ailleurs l'appareil a été calibré avec différents échantillons et donne une mesure avec une erreur de 10 % environ. Les matériaux utilisés pour la calibration sont:

- Plexiglas PMMA            TC = 0,19 W/mK
- Epoxy conductrice thermique    TC = 1,0 W/mK
- Titane TA6V               TC = 6,7 W/mK

Les résultats de mesure de TC sur les matériaux composites de l'invention sont donnés dans le tableau ci-après :

| N° de l'essai | Composite thermoplastique (% en poids) | Conducteur électrique | $TC_{normale}$ mesurée selon l'invention [W/m.K] |
|---|---|---|---|
| 1 | PA12 70 % + 30 % BN | non | 0,60 |
| 2 | PA12 60 % + 40 % BN | non | 0,83 |
| 3 | PA12 50 % + 50 % BN | non | 0,94 |
| 4 | PA1238,2%+60%BN+ 1,8 % additif ag 1 | non | 1,96 |
| 5 | PA1237,6%+60%BN+ 2,4% additif ag 2 | non | 2,15 |
| 6 | PPS 75 % + 25 % BN | non | 0,60 |
| 7 | PPS 60 % + 40 % BN | non | 0,80 |
| 8 | PPS 50 % + 50 % BN | non | 1,06 |
| 9 | PPS 38,2 % + 60 % BN + 1,8 % additif ag 1 | non | 2,05 |
| 10 | PPS 77,6 % + 20 % BN + 2,4 % additif ag 2 | non | 0,88 |
| 11 | PPS 78,2 % + 20 % BN + 1,2 % additif ag 3 | non | 0,88 |
| 12 | PPS 40 % + 40 % BN + 20 % ALN | non | 1,77 |

Les valeurs indiquées sont des moyennes de plusieurs mesures sur des échantillons différents. On constate en première approximation que sans agent de couplage « ag », pour un même type de charge, les TC sont les mêmes pour les deux matrices polymères PPS ou PA12 (essais 2, 3 et 7, 8). En extrapolant ces valeurs on obtient une courbe de référence qui donne la TC en fonction du taux de charge dans une matrice PA12 ou PPS. Les composites avec agent de couplage ou deuxième charge A1N présentent une TC améliorée de 100 % par rapport à cette courbe de référence (essai 12 avec 60 % de taux de charge). Les composites à faible taux de charge confirment cette amélioration (essais 10 et 11 à 20 % de charge BN). Les exemples 1, 4, 5, 6 et 9 ne sont pas selon l'invention et sont donnés uniquement à titre indicatif.

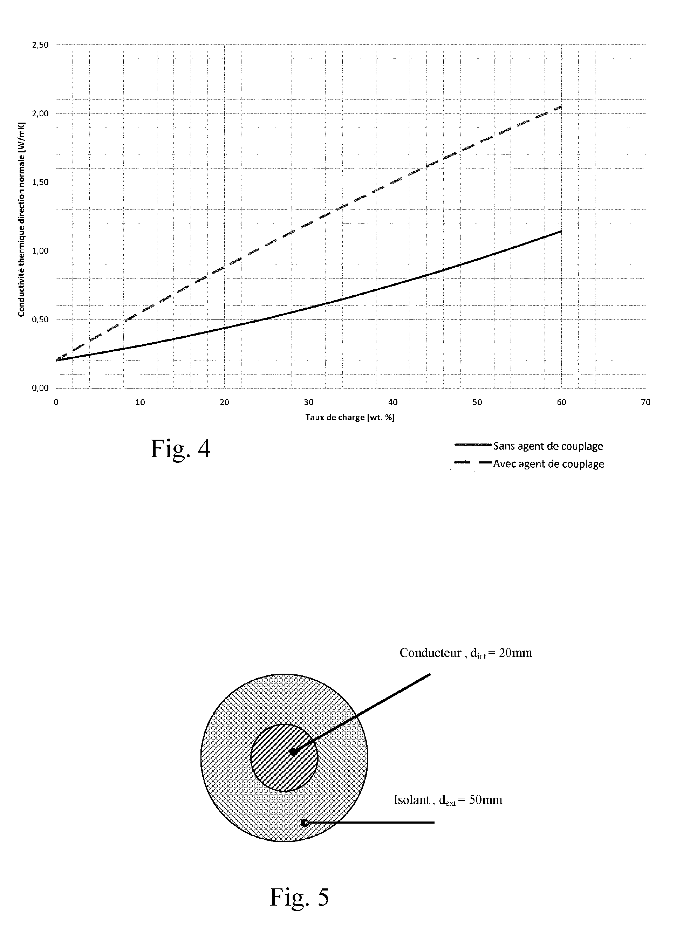

La figure 4 compare les deux courbes de TC : composite de référence (PPS ou PA12 avec hBN) et avec agent de couplage ou deuxième charge. Ces courbes ont été obtenues à partir des valeurs du tableau précédent.

On obtient des composites isolants électriques avec des TC équivalentes aux composites conducteurs électriques du marché, soit plus de 2,0 W/mK avec 60 % de charge. Dans des applications où les propriétés mécaniques sont importantes, on obtient des composites avec une TC de 0,88 W/mK et un taux de charge modéré de 20 %. Il s'agit d'une amélioration de 400 % par rapport à la TC habituelle des thermoplastiques de 0,20 W/mK.

On observe par ailleurs que la $TC_{longitudinal}$ est la plus élevée car dans le sens des fibres, et que les deux autres TC sont du même ordre de grandeur :

- $TC_{transversal} \approx TC_{Normal}$
- $TC_{longitudinal} \approx 2 \times TC_{transversal}$

EXEMPLE : CÂBLE HAUTE TENSION

Comme on peut le voir sur la figure 5, ces câbles contiennent (de manière simplifiée) un conducteur central en cuivre ou alliage d'aluminium et un isolant électrique. Les isolants peuvent être en polyéthylène, PVC ou autre. On considère le modèle thermique d'une longueur L = 1 m de ce câble en régime permanent. Le conducteur central parcouru par un courant I dissipe de la chaleur par effet Joule. On peut calculer la résistance électrique R connaissant la section et la résistivité du cuivre $\rho$=1,72.10$^{-8}$ Ohm.m. Le câble dissipe de la chaleur avec l'extérieur avec un coefficient d'échange h. On considère les environnements suivants :

$$\bullet\; h = 5\; \frac{W}{m^2.K} \quad \text{convection naturelle air}$$

$$\bullet\; h = 10\; \frac{W}{m^2.K} \quad \text{convection naturelle air}$$

$$\bullet\; h = 100\; \frac{W}{m^2.K} \quad \text{convection naturelle eau ou convection forcée air}$$

$$\bullet\; h = 1000\; \frac{W}{m^2.K} \quad \text{convection forcée eau.}$$

Ces environnements couvrent représentent les variantes de montage dudit câble: aérien, sous marin enterré... Le câble peut être représenté par son équivalent électrique qui est celui de deux résistances en série, une résistance de conduction dans l'isolant et une résistance de convection. Le conducteur dissipe une puissance P = R.I$^2$.

La température du conducteur $T_{conducteur}$ dépend de P suivant la loi :

$$\Delta T = (R_{conduction} + R_{convection})*P, \text{ avec } \Delta T = T_{conducteur} - T_{ambiant}$$

Pour un cylindre de longueur L et de diamètre extérieur $d_{ext}$ et de diamètre intérieur $d_{int}$, on a

$$R_{conduction} = \frac{1}{2\pi\lambda L}\ln\left(\frac{d_{ext}}{d_{int}}\right).$$

On a pour la convection : $R_{convection} = \frac{1}{h \cdot S}$, avec S = $\pi$*$d_{ext}$*L, la surface extérieure du câble.

On fixe une température maximale de conducteur de 70 °C, pour un milieu ambiant à 30 °C, en faisant varier la conductivité thermique $\lambda$ normale de l'isolant, et le coefficient d'échange h. Le tableau suivant donne le courant maximum en continu autorisé :

| $\lambda$ [W/m.K] normal | h (W/m$^2$K) fixé à 5 | h (W/m$^2$K) fixé à 10 | h (W/m$^2$K) fixé à 100 | h (W/m$^2$K) fixé à 1000 |
|---|---|---|---|---|
| 0,2 | 604 | 731 | 960 | 997 |
| 1,0 | 717 | 966 | 1867 | 2191 |
| 2,0 | 737 | 1015 | 2313 | 3036 |
| 3,0 | 743 | 1033 | 2552 | 3645 |

Courant max DC en A du câble haute tension, conducteur cuivre de section 314 mm$^2$.

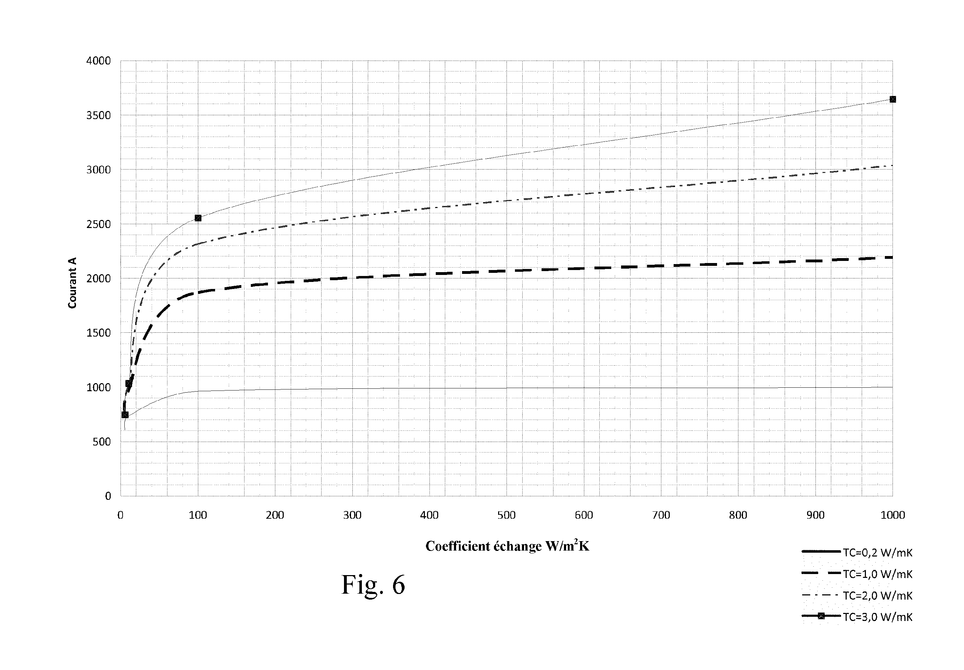

Pour un faible coefficient d'échange la résistance thermique de convection est prépondérante et la conductivité thermique de l'isolant a peu d'influence sur le courant maximum. Pour un coefficient d'échange de 10, une conductivité de 1,0 W/m.K augmente de 235 A le courant maximum autorisé. On comprend tout l'intérêt d'avoir une conductivité thermique au delà de 1,0 W/mK puisque le courant maximum peut être doublé voir triplé selon les conditions (cf. figure 6). En l'occurrence la conductivité thermique normale (radiale dans le cas de l'exemple du câble) est celle qui est la plus pertinente et la plus significative pour optimiser l'échange thermique, ici le refroidissement, du câble.

Bien entendu, l'invention n'est pas limitée aux modes de réalisation décrit et représenté aux dessins annexés. Des modifications restent possibles, notamment du point de vue de la constitution des divers éléments ou par substitution d'équivalents techniques, sans sortir pour autant du domaine de protection de l'invention.

## Revendications

1. Matériau composite électriquement isolant avec une résistivité électrique supérieure à $10^{10}$ $\Omega$.m, **caractérisé en ce qu'**il est constitué, en poids par rapport au poids total dudit matériau composite, par :

   - au moins 45 % d'une matrice de (co)polymère(s) semi-cristallin(s) et thermoplastique(s),
   - entre 20 % et 54,5 % d'une charge de hBN (nitrure de bore hexagonal), destinée à augmenter la conductivité thermique normale d'une pièce formée obtenue par injection ou extrusion dudit matériau composite, ledit hBN utilisé ayant une taille de particules moyenne D50 comprise entre 10 $\mu$m et 45 $\mu$m, de sorte que ladite pièce formée en matériau composite présente une conductivité thermique normale au plan d'injection ou d'extrusion d'au moins 0,8 W/m.K,
   - entre 0,5 % et 5 %, de préférence entre 1 % et 3 %, d'un agent de couplage destiné à améliorer l'affinité entre ledit au moins un (co)polymère et ladite charge,
   la somme des teneurs précitées pondérales étant égale à 100 %.

2. Matériau selon la revendication 1, **caractérisé en ce que** ledit hBN utilisé présente une taille de particules moyenne D50 comprise entre 25 $\mu$m et 35 $\mu$m, de préférence de l'ordre de 30 $\mu$m.

3. Matériau selon la revendication 1 ou 2, **caractérisé en ce que** ledit agent de couplage est choisi dans la famille des silanes, des titanates, des zirconates, de l'acide maléique ou de ses dérivés, ou d'un mélange quelconque de ceux-ci.

4. Matériau selon l'une quelconque des revendications 1 à 3, **caractérisé en ce que** ladite charge de hBN est présente dans ledit matériau composite à raison d'une teneur en poids totale comprise entre 30 % et 54,5 %, ladite pièce formée en matériau composite présentant une conductivité thermique normale au plan d'injection ou d'extrusion d'au moins 1,0 W/m.K, de préférence d'au moins 1,2 W/m.K.

5. Matériau selon l'une quelconque des revendications 1 à 4, **caractérisé en ce qu'**une partie de la charge en hBN est remplacée par une charge constituée d'un isolant électrique isotrope, de sorte qu'il soit présent dans ledit matériau composite à raison d'une teneur en poids comprise entre 2 % et 20 %, ledit isolant isotrope se présentant sous forme de particules sphériques ou de grains compacts d'une substance choisie dans le groupe formée par AlN et Al$_2$O$_3$ ou d'un mélange formé à partir de ceux-ci.

6. Matériau selon l'une quelconque des revendications 1 à 5, **caractérisé en ce qu'**une partie de la charge en hBN et/ou d'isolant isotrope est remplacée par une charge constituée d'un conducteur électrique de sorte qu'il soit présent dans ledit matériau composite à raison d'une teneur en poids comprise entre 2 % et 10 %.

7. Matériau selon la revendication 6, **caractérisé en ce que** ledit conducteur électrique est présent sous la forme de fibres de carbone courtes présentant une longueur moyenne inférieure ou égale à 50 $\mu$m.

8. Matériau selon la revendications 6, **caractérisé en ce que** ledit conducteur électrique présent sous la forme de particules de graphite d'une taille moyenne inférieure ou égale à 50 $\mu$m.

9. Matériau selon l'une quelconque des revendications 1 à 8, **caractérisé en ce que** le ou les (co)polymère(s) semi-cristallin(s) et thermoplastique(s) présente(nt), seul ou ensemble, un module d'Young en traction d'au moins 1500 MPa.

10. Matériau selon l'une quelconque des revendications 1 à 9, **caractérisé en ce que** au moins un (co)polymère de la matrice est choisi dans le groupe formé par : les polyamides, en particulier le polyamide PA 6, PA 12 et PA 66; le poly(sulfure de phénylène) ; les polyesters, en particulier le poly(butylène téréphtalate), et le poly(éthylène téréphtalate) ; le poly(oxyméthylène), les polyoléfines, en particulier le polypropylène, le polyéthylène ; les polyétheréthercétones, le poly(chlorure de vinyle), le poly(tétrafluoroéthylène) et tous les mélanges compatibles de polymères et/ou copolymères des familles précitées.

11. Pièce formée, notamment par extrusion ou injection d'un matériau composite selon l'une quelconque des revendications 1 à 10, **caractérisée en ce qu'**elle présente une conductivité thermique normale au plan d'injection ou d'extrusion d'au moins 0,8 W/m.K, de préférence d'au moins 1,0 W/m.K et plus préférentiellement d'au moins 1,2 W/m.K.

12. Utilisation d'une pièce formée selon la revendication 11, notamment sous la forme d'un tube, d'une gaine, d'une ailette ou similaire comme élément d'échange thermique dans un dispositif dans lequel a lieu un échange de calories, notamment de type radiateur, échangeur de chaleur, circuit de refroidissement, gaine électriquement isolante de câbles électriques, et analogues.

Fig. 1

Fig. 2

Fig. 3

Fig. 4

Sans agent de couplage
Avec agent de couplage

Conducteur, $d_{int} = 20mm$

Isolant, $d_{ext} = 50mm$

Fig. 5

Fig. 6

Europäisches
Patentamt

European
Patent Office

Office européen
des brevets

**RAPPORT DE RECHERCHE EUROPEENNE**

Numéro de la demande

EP 12 30 5045

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| Y | US 2008/277619 A1 (MATSUMOTO KAZUAKI [JP] ET AL) 13 novembre 2008 (2008-11-13) <br> * alinéas [0010], [0108], [0138] * <br> * exemples 6,16,23 * <br> ----- | 1-12 | INV. <br> C08K3/38 <br> C08K9/04 <br> H01L23/373 <br> H01B3/00 |
| Y | WO 00/42098 A1 (FERRO CORP [US]) 20 juillet 2000 (2000-07-20) <br> * exemples * <br> * page 2, ligne 11-12 * <br> * page 5, ligne 1-5 * <br> ----- | 1-12 | |
| Y | EP 1 702 907 A2 (GEN ELECTRIC [US]) 20 septembre 2006 (2006-09-20) <br> * le document en entier * <br> ----- | 1-12 | |
| Y | WO 2010/141432 A1 (ROGERS CORP [US]; PAUL SANKAR K [US]) 9 décembre 2010 (2010-12-09) <br> * alinéa [0016] * <br> * exemples * <br> ----- | 1-12 | |
| T | BOWEN P: "Particle Size Distribution Measurement from Millimeters to Nanometers and from Rods to Platelets", JOURNAL OF DISPERSION SCIENCE AND TECHNOLOGY, TAYLOR AND FRANCIS GROUP, NEW YORK, NY, US, vol. 23, no. 5, 1 janvier 2002 (2002-01-01), pages 631-662, XP009102859, ISSN: 0193-2691, DOI: 10.1081/DIS-120015368 <br> * le document en entier * <br> ----- | | **DOMAINES TECHNIQUES RECHERCHES (IPC)** <br><br> C08K <br> H01L <br> H01B |

Le présent rapport a été établi pour toutes les revendications

| Lieu de la recherche | Date d'achèvement de la recherche | Examinateur |
|---|---|---|
| Munich | 13 juillet 2012 | Behm, Sonja |

CATEGORIE DES DOCUMENTS CITES

X : particulièrement pertinent à lui seul
Y : particulièrement pertinent en combinaison avec un
    autre document de la même catégorie
A : arrière-plan technologique
O : divulgation non-écrite
P : document intercalaire

T : théorie ou principe à la base de l'invention
E : document de brevet antérieur, mais publié à la
    date de dépôt ou après cette date
D : cité dans la demande
L : cité pour d'autres raisons
................................................................
& : membre de la même famille, document correspondant

EPO FORM 1503 03.82 (P04C02)

**EP 2 615 133 A1**

**ANNEXE AU RAPPORT DE RECHERCHE EUROPEENNE
RELATIF A LA DEMANDE DE BREVET EUROPEEN NO.**

EP 12 30 5045

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

13-07-2012

| Document brevet cité au rapport de recherche | Date de publication | Membre(s) de la famille de brevet(s) | Date de publication |
|---|---|---|---|
| US 2008277619 A1 | 13-11-2008 | US 2008277619 A1<br>WO 2007066711 A1 | 13-11-2008<br>14-06-2007 |
| WO 0042098 A1 | 20-07-2000 | AU 2501000 A<br>US 6162849 A<br>WO 0042098 A1 | 01-08-2000<br>19-12-2000<br>20-07-2000 |
| EP 1702907 A2 | 20-09-2006 | CN 1834167 A<br>EP 1702907 A2<br>JP 2006257392 A<br>KR 20060100914 A<br>US 2007041918 A1 | 20-09-2006<br>20-09-2006<br>28-09-2006<br>21-09-2006<br>22-02-2007 |
| WO 2010141432 A1 | 09-12-2010 | AUCUN | |

EPO FORM P0460

Pour tout renseignement concernant cette annexe : voir Journal Officiel de l'Office européen des brevets, No.12/82